(19) Europäisches Patentamt
European Patent Office
Office européen des brevets

(11) EP 2 715 806 B1

## (12) EUROPÄISCHE PATENTSCHRIFT

(45) Veröffentlichungstag und Bekanntmachung des Hinweises auf die Patenterteilung:
**23.08.2017** **Patentblatt 2017/34**

(21) Anmeldenummer: **12724107.3**

(22) Anmeldetag: **16.05.2012**

(51) Int Cl.:
*H01L 33/00* (2010.01)          *F21K 9/90* (2016.01)
*H01L 25/075* (2006.01)          *H01L 27/15* (2006.01)

(86) Internationale Anmeldenummer:
**PCT/EP2012/059171**

(87) Internationale Veröffentlichungsnummer:
**WO 2012/163685 (06.12.2012 Gazette 2012/49)**

### (54) VERFAHREN ZUR ANORDNUNG EINER VIELZAHL VON LEDS IN VERPACKUNGSEINHEITEN

METHOD FOR ARRANGING A PLURALITY OF LEDS IN PACKAGING UNITS

PROCÉDÉ POUR PLACER UNE PLURALITÉ DE DEL DANS DES UNITÉS D'EMBALLAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.05.2011 DE 102011103752**

(43) Veröffentlichungstag der Anmeldung:
**09.04.2014 Patentblatt 2014/15**

(73) Patentinhaber: **OSRAM Opto Semiconductors GmbH**
**93055 Regensburg (DE)**

(72) Erfinder:
• **WILM, Alexander**
**93059 Regensburg (DE)**
• **SCHULZ, Roland**
**93059 Regensburg (DE)**
• **MICHEL, Felix**
**81669 München (DE)**

(74) Vertreter: **Epping - Hermann - Fischer Patentanwaltsgesellschaft mbH**
**Schloßschmidstraße 5**
**80639 München (DE)**

(56) Entgegenhaltungen:
**WO-A1-2008/110142      JP-A- 2008 147 563**
**US-A1- 2004 227 869      US-A1- 2011 037 080**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Anordnung von LEDs in Verpackungseinheiten.

Diese Patentanmeldung beansprucht die Priorität der deutschen Patentanmeldung 10 2011 103 752.0.

Aufgrund ihrer hohen Effizienz werden LEDs zunehmend in LED-Lampen zur Allgemeinbeleuchtung oder in Automobilscheinwerfern eingesetzt. Dabei ist es oft der Fall, dass mehrere LED-Lampen nebeneinander betrieben werden, wobei die einzelnen LED-Lampen jeweils mehrere LEDs enthalten können.

Damit verschiedene nebeneinander angeordnete LED-Lampen ein hinsichtlich ihrer Helligkeit und/oder ihrer Farbe homogenes Erscheinungsbild bieten, ist es wünschenswert, dass die von den verschiedenen LED-Lampen emittierte Strahlung jeweils die gleiche Helligkeit und/oder den gleichen Farbort aufweist. Allerdings ist es bei der Fertigung von LEDs nicht auszuschließen, dass geringe Helligkeits- oder Farbabweichungen der einzelnen LEDs auftreten, insbesondere bei LEDs aus verschiedenen Produktionsserien. Aus diesem Grund werden LEDs vom LED-Hersteller oftmals vor der Auslieferung gruppiert (so genanntes Binning), wobei sich eine Gruppe von LEDs (der sogenannte Bin) beispielsweise dadurch auszeichnet, dass alle LEDs dieser Gruppe die gleiche Helligkeit und/oder den gleichen Farbort aufweisen.

Wenn bei der Herstellung von LED-Lampen nur LEDs aus einer einzigen Gruppe verwendet werden, ist sichergestellt, dass alle mit diesen LEDs bestückten Leuchten die gleiche Helligkeit und/oder den gleichen Farbort aufweisen. In diesem Fall ist es aber notwendig, dass der Kunde des LED-Herstellers, der die einzelnen LEDs zu LED-Lampen weiterverarbeitet, jeweils nur LEDs aus der gleichen LED-Gruppe verwendet, sodass alle Leuchten verschiedener Fertigungsserien die gleiche Helligkeit und/oder den gleichen Farbort aufweisen. Alternativ wäre es auch denkbar, dass ein Leuchtenhersteller für die Bestückung einer LED-Lampe gezielt mehrere LEDs aus verschiedenen LED-Gruppen mit verschiedenen Helligkeiten und/oder Farborten derart auswählt, dass die mehrere LEDs enthaltende Leuchte insgesamt die gewünschten Sollwerte für die Helligkeit und/oder den Farbort aufweist. Dies hätte den Vorteil, dass der Leuchtenhersteller LEDs aus Gruppen mit unterschiedlichen Helligkeiten und/oder Farborten verwenden könnte, führt aber andererseits zu einem erhöhten Herstellungsaufwand, da für die Bestückung einer einzelnen LED-Lampe LEDs aus verschiedenen Verpackungseinheiten verwendet werden müssten.

Ein Verfahren zur Anordnung von LEDs in einer Verpackungseinheit derart, dass Gruppen von LEDs in einem Sollwertebereich für eine Farbtemperatur und Lichtintensität liegen, und eine solche Verpackungseinheit sind aus der Druckschrift JP 2008 147563 A bekannt.

Eine Aufgabe besteht darin, ein Verfahren zur Anordnung von LEDs in einer Verpackungseinheit anzugeben, durch das erreicht wird, dass ein LED-Bauelement, dass eine vorgegebene Anzahl von LEDs aufweist, einen Sollwertebereich für mindestens eine fotometrischen Messgröße erfüllt, wobei der Aufwand für die Bestückung des LED-Bauelements mit LEDs aus der Verpackungseinheit gering ist.

Diese Aufgabe wird durch ein Verfahren zur Anordnung einer Vielzahl von LEDs in Verpackungseinheiten gemäß Anspruch 1 gelöst. Vorteilhafte Ausgestaltungen und Weiterbildungen der Erfindung sind Gegenstand der abhängigen Ansprüche.

Es wird ein Verfahren angegeben, mit dem eine Vielzahl von LEDs in mehreren Verpackungseinheiten angeordnet wird.

Gemäß zumindest einer Ausführungsform des Verfahrens wird in einem ersten Schritt ein Sollwertebereich für mindestens eine fotometrische Messgröße für jede der Verpackungseinheiten festgelegt, wobei der Mittelwert der fotometrischen Messgröße für eine feste Anzahl von $N \geq 3$ aufeinander folgenden LEDs in den Verpackungseinheiten in dem Sollwertebereich liegen soll.

Bei einer Ausgestaltung des Verfahrens sind der Sollwertebereich und die feste Anzahl N der aufeinander folgenden LEDs, für die der Mittelwert der fotometrischen Messgröße im Sollwertebereich liegen soll, für die mehreren Verpackungseinheiten gleich. Beispielsweise kann vorgesehen sein, dass jeweils vier aufeinander folgende LEDs, die aus einer der Verpackungseinheiten entnommen werden sollen, einen Mittelwert der fotometrischen Messgröße aufweisen sollen, der im Sollwertebereich liegen soll. In diesem Fall ist also für alle Verpackungseinheiten N = 4.

Es ist alternativ aber auch möglich, dass die mehreren Verpackungseinheiten sich in dem Sollwertebereich und/oder der festen Anzahl N von aufeinander folgenden LEDs, für die der Mittelwert der mindestens einen fotometrischen Messgröße in dem Sollwertebereich liegt, unterscheiden. Beispielsweise kann vorgesehen sein, dass drei Verpackungseinheiten gleichzeitig bestückt werden, wobei der Mittelwert der fotometrischen Messgröße in der ersten Verpackungseinheit für $N_1 = 3$ aufeinanderfolgende LEDs im Sollwertebereich liegen soll. Für die zweite Verpackungseinheit soll der Mittelwert der fotometrischen Messgröße beispielsweise für $N_2 = 5$ aufeinander folgende LEDs im Sollwertebereich liegen, und für die dritte Verpackungseinheit für $N_3 = 7$ aufeinander folgende LEDs. Die Anzahl N von in der Verpackungseinheit aufeinander folgenden LEDs, für die der Mittelwert der fotometrischen Messgröße im Sollwertebereich liegen soll, wird vorzugsweise nach der Anzahl der LEDs festgelegt, die der Kunde des LED-Herstellers zur Bestückung von optoelektronischen Bauelementen den Verpackungseinheiten entnimmt. Wenn beispielsweise mit den LEDs aus einer Verpackungseinheit jeweils optoelektronische Bauelemente mit 5 LEDs bestückt werden sollen, wird für die Verpackungseinheit N = 5 festgelegt. Die Verpackungseinheit wird in diesem Fall mit dem im Folgenden beschriebenen Verfahren derart bestückt, dass jeweils 5 aufeinander folgende LEDs, die an einer beliebigen Stelle in der Reihenfolge ihrer Anordnung der Verpackungseinheit entnommen werden, einen Mittelwert der fotometrischen Messgröße aufweisen, der im vorgegebenen Sollwertebereich liegt.

Bei dem Verfahren wird die Vielzahl von LEDs bereitgestellt, beispielsweise in einem Vorratsbehälter, aus dem die LEDs vorzugsweise automatisch einzeln entnommen werden können. Die Vielzahl von LEDs kann beispielsweise mehr als 1000 oder sogar mehr als 10000 LEDs umfassen. Insbesondere kann es sich bei der Vielzahl von LEDs um eine Fertigungsserie von gleichartigen LEDs handeln, die vor der Auslieferung an einen Kunden des LED-Herstellers in Verpackungseinheiten angeordnet werden sollen. Weiterhin werden die mehreren Verpackungseinheiten, in denen die LEDs angeordnet werden sollen, bereitgestellt.

Gemäß zumindest einer Ausführungsform wird aus der Vielzahl von LEDs eine LED ausgewählt, die noch nicht in einer der Verpackungseinheiten angeordnet ist. Die ausgewählte LED ist beispielsweise eine beliebige aus dem Vorratsbehälter entnommene LED.

Nachfolgend wird für die ausgewählte LED die mindestens eine fotometrische Messgröße gemessen.

In einem weiteren Schritt wird eine der Verpackungseinheiten, die noch weniger als N - 1 LEDs enthält, mit der ausgewählten LED bestückt. Die LEDs werden in den Verpackungseinheiten jeweils in der Reihenfolge der Bestückung aneinander gereiht. Mit anderen Worten werden die LEDs in den Verpackungseinheiten sequenziell angeordnet, wobei die zuerst in der Verpackungseinheit angeordnete LED an erster Stelle, die als zweite in der Verpackungseinheit angeordnete LED an zweiter Stelle, die als dritte angeordnete LED an dritter Stelle und so weiter angeordnet werden. Die LEDs können daher in der Reihenfolge oder der umgekehrten Reihenfolge, in der die Verpackungseinheit mit den LEDs bestückt wurde, wieder aus der Verpackungseinheit entnommen werden.

Der Messwert der mindestens einen fotometrischen Messgröße und die Position der ausgewählten LED in der Verpackungseinheit werden vorteilhaft in einem Datenspeicher gespeichert.

Die Schritte des Auswählens einer LED, des Messens der mindestens einen fotometrischen Messgröße der ausgewählten LED, des Bestückens einer der Verpackungseinheiten mit der ausgewählten LED und das Speichern des Messwerts und der Position der ausgewählten LED werden nachfolgend wiederholt, bis alle Verpackungseinheiten mit N - 1 LEDs bestückt sind.

Gemäß zumindest einer Ausführungsform wird nachfolgend eine weitere LED ausgewählt, die noch nicht in einer der Verpackungseinheiten angeordnet ist, und die mindestens eine fotometrische Messgröße für die ausgewählte LED gemessen.

Nachfolgend wird der Mittelwert der mindestens einen fotometrischen Messgröße, der sich jeweils für die zuletzt in der Verpackungseinheit angeordneten N - 1 LEDs und der ausgewählten LED ergibt, berechnet, wobei diese Berechnung vorzugsweise für alle Verpackungseinheiten durchgeführt wird. Dazu werden die Messwerte der zuletzt in der jeweiligen Verpackungseinheit angeordneten N-1 LEDs aus dem Datenspeicher ausgelesen. Es wird geprüft, ob für zumindest eine Verpackungseinheit die Anzahl von N LEDs, die sich durch Addition der ausgewählten LED zu den zuletzt in der Verpackungseinheit angeordneten N - 1 LEDs ergibt, einen Mittelwert der mindestens einen fotometrischen Messgröße aufweist, der in dem festgelegten Sollwertebereich liegt.

In einem weiteren Schritt wird vorteilhaft eine Verpackungseinheit mit der ausgewählten LED bestückt, für die der auf diese Weise berechnete Mittelwert der mindestens einen fotometrischen Messgröße in dem zuvor festgelegten Sollwertebereich liegt. Auf diese Weise wird sichergestellt, dass die zuletzt in der Verpackungseinheit angeordneten N LEDs einen Mittelwert der fotometrischen Messgröße aufweisen, der in dem festgelegten Sollwertebereich liegt. Die ausgewählte LED wird bei diesem Verfahrensschritt derart in der Verpackungseinheit angeordnet, dass sie unmittelbar auf die zuletzt in der Verpackungseinheit angeordnete LED folgt. Die LEDs werden also in der Reihenfolge der Bestückung aneinandergereiht.

Falls der Mittelwert der mindestens einen fotometrischen Messgröße für die zuletzt in der Verpackungseinheit angeordneten N - 1 LEDs und der ausgewählten LED für keine der Verpackungseinheiten in dem zuvor festgelegten Sollwertebereich liegt, kann die ausgewählte LED keiner der Verpackungseinheiten zugeordnet werden, und wird aussortiert. Die aussortierten LEDs werden vorzugsweise in einer Zwischenablage abgelegt oder wieder dem Vorratsbehälter zugeführt, da sie möglicherweise in einem späteren Verfahrensschritt einer der Verpackungseinheiten zugeordnet werden können.

Der Messwert der mindestens einen fotometrischen Messgröße und die Position der ausgewählten LED in der Verpackungseinheit werden vorteilhaft in dem Datenspeicher gespeichert.

Die Schritte des Auswählens einer LED, der Berechnung des Mittelwerts der fotometrischen Messgröße, das Bestücken einer Verpackungseinheit mit der ausgewählten LED und das Speichern des Messwerts und der Position, oder gegebenenfalls das Aussortieren der LED, werden nachfolgend so oft wiederholt, bis die Verpackungseinheiten mit der gewünschten Gesamtzahl von LEDs bestückt sind.

Mit dem beschriebenen Verfahren werden die Verpackungseinheiten vorteilhaft derart mit LEDs bestückt, dass jeweils eine Anzahl von genau N LEDs einen Mittelwert der mindestens einen fotometrischen Messgröße aufweist, der in dem zuvor festgelegten Sollwertebereich liegt. Wenn also genau N aufeinander folgende LEDs aus der Verpackungseinheit entnommen werden, ist sichergestellt, dass der Mittelwert der fotometrischen Messgröße für diese Anzahl von N LEDs in dem vorgegebenen Sollwertebereich liegt. Bei der Entnahme der LEDs aus der Verpackungseinheit ist es dabei unerheblich, von welcher Stelle der Verpackungseinheit die erste LED der Sequenz entnommen wird. Insbesondere liegt der Mittelwert der mindestens einen fotometrischen Messgröße einer Sequenz von genau N aufeinander folgender LEDs auch dann in dem vorgegebenen Sollwertebereich, wenn die LEDs in der umgekehrten Reihenfolge der Bestückung aus der Verpackungseinheit entnommen werden. Weiterhin liegt auch der Mittelwert von ganzzahligen Vielfachen der Anzahl von N LEDs im Sollwertebereich. Eine mit der Anzahl N gekennzeichnete Verpackungseinheit, die zur Bestückung von Bauelementen mit N LEDs vorgesehen ist, kann also auch zur Bestückung von Bauelementen mit 2N LEDs, 3N LEDs usw. verwendet werden.

Dadurch, dass jeweils genau N aufeinanderfolgende LEDs aufgrund des hier beschriebenen Verfahrens der Anordnung in der Verpackungseinheit mit Sicherheit einen Mittelwert der fotometrischen Messgröße im Sollwertebereich aufweisen, ist selbstverständlich nicht ausgeschlossen, dass dies auch für eine andere Anzahl von LEDs in der Verpackungseinheit der Fall sein kann.

Das hierin beschriebene Verfahren zur Anordnung von LEDs in Verpackungseinheiten ist insbesondere dann vorteilhaft, wenn die Verpackungseinheiten zur Bestückung von optoelektronischen Bauelementen vorgesehen sind, die jeweils eine feste Anzahl N LEDs aufweisen, wobei die N LEDs im Mittel einen Sollwert für eine fotometrische Messgröße einhalten müssen. Insbesondere ist die hierin beschriebene Anordnung von LEDs in Verpackungseinheiten für die Bestückung von Bauelementen vorteilhaft, bei denen zumindest geringfügige Unterschiede in der mindestens einen fotometrischen Messgröße einzelner LEDs tolerierbar sind, wenn der Mittelwert der N LEDs den Sollwert der mindestens einen fotometrischen Messgröße erfüllt. Dies ist beispielsweise bei optoelektronischen Bauelementen der Fall, bei denen die mehreren LEDs, zum Beispiel aufgrund einer lichtstreuenden Abdeckung, nicht oder nur schwer einzeln wahrnehmbar sind.

Bei einer vorteilhaften Ausgestaltung ist die mindestens eine fotometrische Messgröße die Helligkeit der LEDs. In diesem Fall werden die LEDs in den Verpackungseinheiten vorteilhaft derart angeordnet, dass jeweils eine Sequenz von N aufeinander folgenden LEDs im Mittel eine Helligkeit aufweist, die in dem festgelegten Sollwertebereich liegt.

Bei einer weiteren Ausgestaltung ist die mindestens eine fotometrische Messgröße der Farbort der LEDs. Der Farbort kann insbesondere durch die Koordinaten $C_x$ und $C_y$ im CIE-Farbdiagramm angegeben werden. Bei dieser Ausgestaltung liegt der Mittelwert der Farbkoordinaten $C_x$, $C_y$ von N aufeinander folgenden LEDs in den Verpackungseinheiten jeweils in dem festgelegten Sollwertebereich. Somit weist diese feste Anzahl von N LEDs jeweils den gleichen Farbeindruck auf.

Es ist möglich, dass bei dem Verfahren mehrere fotometrische Messgrößen für die Anordnung der LEDs herangezogen werden. Bei einer besonders bevorzugten Ausgestaltung sind die fotometrischen Messgrößen sowohl die Helligkeit als auch der Farbort der LEDs. Bei dieser Ausgestaltung werden die LEDs in den Verpackungseinheiten also derart angeordnet, dass für eine vorgegebene Anzahl von N LEDs sowohl der Mittelwert der Helligkeit als auch die Mittelwerte der Farbkoordinaten in vorgegebenen Sollwertbereichen liegen. Auf diese Weise wird sichergestellt, dass eine feste Anzahl von N aufeinander folgenden LEDs den Anforderungen an eine vorgegebene Helligkeit und einen vorgegebenen Farbort erfüllen.

Alternativ und/oder zusätzlich zu der Helligkeit und/oder dem Farbort kann auch eine andere fotometrische Messgröße bei dem Verfahren herangezogen werden, um die LEDs in den Verpackungseinheiten gezielt anzuordnen. Beispielsweise kann die fotometrische Messgröße der Farbwiedergabeindex CRI (Colour Rendering Index) oder die Wellenlänge $\lambda_{max}$ des Intensitätsmaximums der LED sein. Weiterhin ist es auch möglich, dass zusätzlich zu der mindestens einen fotometrischen Messgröße eine elektrische Messgröße zur Anordnung der LEDs in der Verpackungseinheit herangezogen wird. Bei der elektrischen Messgröße kann es sich beispielsweise um die Vorwärtsspannung $U_f$ der LEDs handeln.

Bei dem Verfahren beträgt die Anzahl der Verpackungseinheiten vorzugsweise mindestens vier. Beispielsweise können zwischen einschließlich vier und einschließlich zehn Verpackungseinheiten gleichzeitig bestückt werden.

Bei den Verpackungseinheiten der LEDs kann es sich insbesondere um Rollen handeln. Die LEDs werden auf der Rolle vorzugsweise derart auf einem Band fixiert, dass sie leicht von der Rolle entnommen werden können. Die LEDs können von der Rolle in einfacher Weise in der Reihenfolge oder der umgekehrten Reihenfolge entnommen werden, in der die Rolle mit den LEDs bestückt wurde.

Bei einer bevorzugten Ausgestaltung werden die Verpackungseinheiten mit der Anzahl N der aufeinander folgenden LEDs, für die der Mittelwert der mindestens einen fotometrischen Messgröße im Sollwertebereich liegt, gekennzeichnet. Ein Kunde des LED-Herstellers, der die Verpackungseinheiten zur Bestückung von optoelektronischen Bauelementen verwendet, kann daher der Verpackungseinheit entnehmen, welche Anzahl N von aufeinander folgenden LEDs einen Mittelwert der mindestens einen fotometrischen Messgröße aufweist, der im Sollwertebereich liegt. Zur Bestückung von optoelektronischen Bauelementen, die jeweils eine Anzahl von N LEDs aufweisen, kann daher eine Verpackungseinheit ausgewählt werden, die mit dem Wert N gekennzeichnet ist.

Vorzugsweise werden die Verpackungseinheiten mit der mindestens einen fotometrischen Messgröße und dem dazugehörigen Sollwertebereich gekennzeichnet.

Die Anzahl N von LEDs, für die der Mittelwert der mindestens einen fotometrischen Messgröße im Sollwertebereich liegt, beträgt vorzugsweise zwischen einschließlich drei und einschließlich 25, besonders bevorzugt zwischen einschließlich drei und einschließlich 15.

Die Gesamtzahl der in den Verpackungseinheiten angeordneten LEDs ist vorteilhaft wesentlich größer als die Anzahl N.

Vorzugsweise ist die Gesamtzahl der in den Verpackungseinheiten angeordneten LEDs mindestens um einen Faktor 20, einen Faktor 100 oder sogar einen Faktor 500 größer als die Anzahl N.

Die Gesamtzahl der in Verpackungseinheiten angeordneten LEDs beträgt vorteilhaft jeweils mindestens 500. Bevorzugt beträgt die Gesamtzahl der in den Verpackungseinheiten angeordneten LEDs jeweils mindestens 1000 oder sogar mindestens 5000. Beispielsweise können die Verpackungseinheiten zwischen einschließlich 500 und einschließlich 20000 LEDs enthalten.

Ein Ausführungsbeispiel des Verfahrens zur Anordnung einer Vielzahl von LEDs in Verpackungseinheiten und eine mit dem Verfahren herstellbare Verpackungseinheit werden im Folgenden im Zusammenhang mit den Figuren 1 bis 9 näher erläutert.

Es zeigen:

Figuren 1 bis 8 eine Darstellung eines Ausführungsbeispiels des Verfahrens zur Anordnung einer Vielzahl von LEDs in Verpackungseinheiten anhand von schematisch dargestellten Zwischenschritten und

Figur 9 eine schematische Darstellung von mit dem Verfahren herstellbaren Verpackungseinheiten, die jeweils eine Vielzahl von LEDs aufweisen.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

Mit dem hierin beschriebenen Verfahren wird eine Vielzahl von LEDs, beispielsweise eine bei einem LED-Hersteller hergestellte Fertigungsserie, in Verpackungseinheiten verpackt, um sie beispielsweise an einen Kunden auszuliefern.

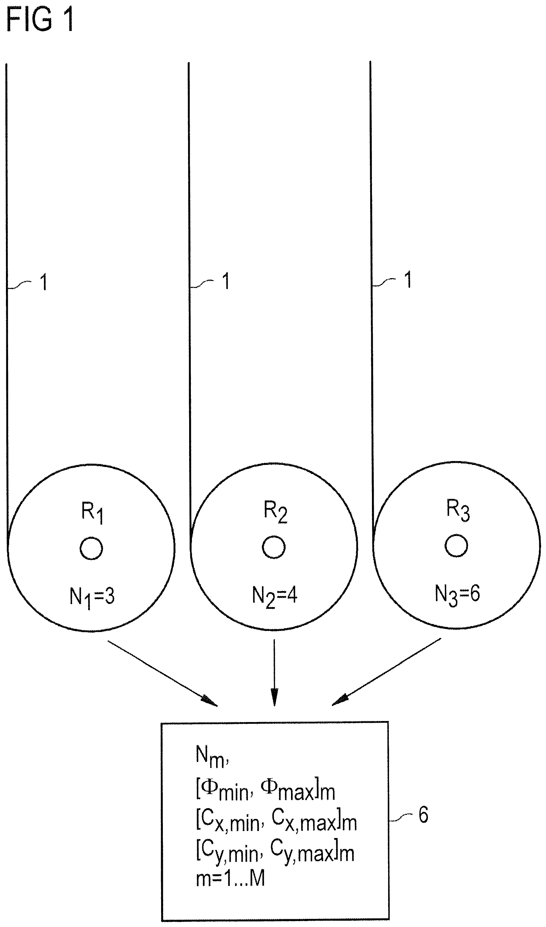

Wie in Figur 1 dargestellt, kann es sich bei den Verpackungseinheiten beispielsweise um Rollen $R_1$, $R_2$, $R_3$ handeln. Die Rollen weisen jeweils ein Band 1 auf, auf dem die LEDs fixiert werden können. Zur Vereinfachung der Darstellung wird das Verfahren im Folgenden anhand eines Ausführungsbeispiels mit drei Verpackungseinheiten $R_1$, $R_2$, $R_3$ dargestellt. Bei dem Verfahren können aber auch mehr Verpackungseinheiten verwendet werden, wobei vorzugsweise mindestens vier Verpackungseinheiten eingesetzt werden.

Bei dem Verfahren ist vorgesehen, dass in jeder der M Verpackungseinheiten, wobei M die Anzahl der Verpackungseinheiten ist, eine feste Anzahl $N_m$ (m = 1 bis M) von aufeinanderfolgen LEDs einen Mittelwert von zumindest einer fotometrischen Messgröße aufweist, der in einem vorgegebenen Sollwertebereich liegt.

Diese Anzahl $N_m$ kann für die Verpackungseinheiten, die gleichzeitig bestückt werden, verschieden sein. Beispielsweise werden bei dem in Figur 1 dargestellten Ausführungsbeispiel eine erste Verpackungseinheit $R_1$, für die $N_1$ = 3 festgelegt wird, eine zweite Verpackungseinheit $R_2$, für die $N_2$ = 4 festgelegt wird, und eine dritte Verpackungseinheit $R_3$, für die $N_3$ = 6 festgelegt wird, gleichzeitig mit LEDs bestückt. Die Anzahl $N_m$ kann also für alle Verpackungseinheiten m = 1 bis M separat bestimmt werden. Alternativ wäre es auch möglich, dass $N_m$ für alle Verpackungseinheiten gleich ist.

Weiterhin wird für jede der Verpackungseinheiten $R_1$, $R_2$, $R_3$ ein Sollwertebereich für mindestens eine fotometrische Messgröße festgelegt, der von dem Mittelwert der jeweils $N_m$ LEDs erfüllt werden soll. Die fotometrische Messgröße kann insbesondere die Helligkeit $\Phi$ sein. Vorteilhaft wird für jede der Verpackungseinheiten ein Intervall $[\Phi_{min}, \Phi_{max}]_m$ für m = 1 bis M als Sollwertebereich festgelegt, wobei $\Phi_{min}$ die zulässige Minimalhelligkeit und $\Phi_{max}$ die zulässige Maximalhelligkeit ist. Es ist möglich, dass der Sollwertebereich für alle Verpackungseinheiten gleich ist. Alternativ können aber auch verschiedene Sollwertbereiche für die Verpackungseinheiten festgelegt werden.

Bei einer vorteilhaften Ausgestaltung werden eine oder mehrere weitere fotometrische Messgrößen herangezogen, um die LEDs in den Verpackungseinheiten anzuordnen. Zusätzlich oder alternativ zur Helligkeit kann insbesondere der Farbort der LEDs als fotometrische Messgröße herangezogen werden. Der Farbort einer LED kann beispielsweise durch die Farbkoordinaten $C_x$ und $C_y$ im CIE-Farbdiagramm angegeben werden. Bei dem hier beschriebenen Ausführungsbeispiel werden vorteilhaft sowohl die Helligkeit $\Phi$ als auch die Farbkoordinaten $C_x$, $C_y$ als fotometrische Messgrößen für die Anordnung der LEDs in den Verpackungseinheiten herangezogen. Wie für die Helligkeit $\Phi$ wird auch für die Farbkoordinaten $C_x$ und $C_y$ jeweils ein Sollwertebereich $[C_{x,min}, C_{x,max}]_m$ und $[C_{y,min}, C_{y,max}]_m$ für m = 1 bis M festgelegt. Die Sollwertbereiche für die Farbkoordinaten können für alle Verpackungseinheiten gleich sein oder verschiedene Werte aufweisen. Die festegelegten Anzahlen Nm und die Sollwertebereiche werden vorteilhaft in einem Datenspeicher 6 gespeichert.

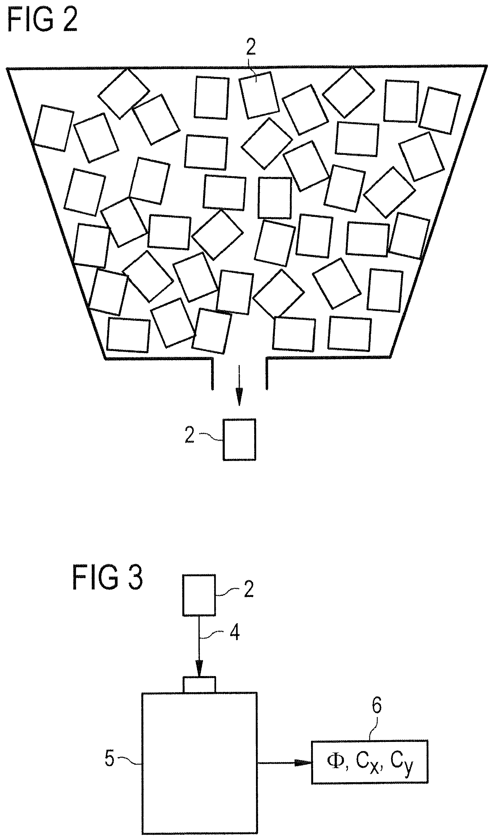

Wie in Figur 2 dargestellt, wird die Vielzahl von LEDs 2, die in Verpackungseinheiten angeordnet werden sollen, beispielsweise in einem Vorratsbehälter 3 bereitgestellt, aus dem die LEDs 2 einzeln entnommen werden können. Bei dem Verfahren werden die LEDs 2 nacheinander dem Vorratsbehälter 3 entnommen und auf die mehreren Verpackungseinheiten aufgeteilt.

Für eine ausgewählte LED 2 wird nachfolgend, wie in Figur 3 schematisch dargestellt, die mindestens eine fotometrische Messgröße gemessen. Dazu wird die von der LED 2 emittierte Strahlung 4 beispielsweise mit einem Spektralfotometer 5 und/oder einer Fotodiode gemessen. Bei dem hier beschriebenen Ausführungsbeispiel werden die Helligkeit $\Phi$ und die Farbkoordinaten $C_x$, $C_y$ der LED 2 gemessen. Alternativ wäre es aber auch möglich, dass eine andere fotometrische Messgröße gemessen wird, beispielsweise die Wellenlänge $\lambda_{max}$ des Intensitätsmaximums und/oder der Farbwiedergabeindex (CRI). Weiterhin ist es auch möglich, dass zusätzlich zu der mindestens einen fotometrischen Messgröße eine elektrische Messgröße der LED 2, beispielsweise die Vorwärtsspannung $U_f$, gemessen wird. Der Messwert der mindestens einen fotometrischen Messgröße wird in einem Datenspeicher gespeichert. Bei dem hier dargestellten Beispiel werden also die Helligkeit $\Phi$ und die Farbkoordinaten $C_x$, $C_y$ für die ausgewählte LED 2 in einem Datenspeicher 6 gespeichert.

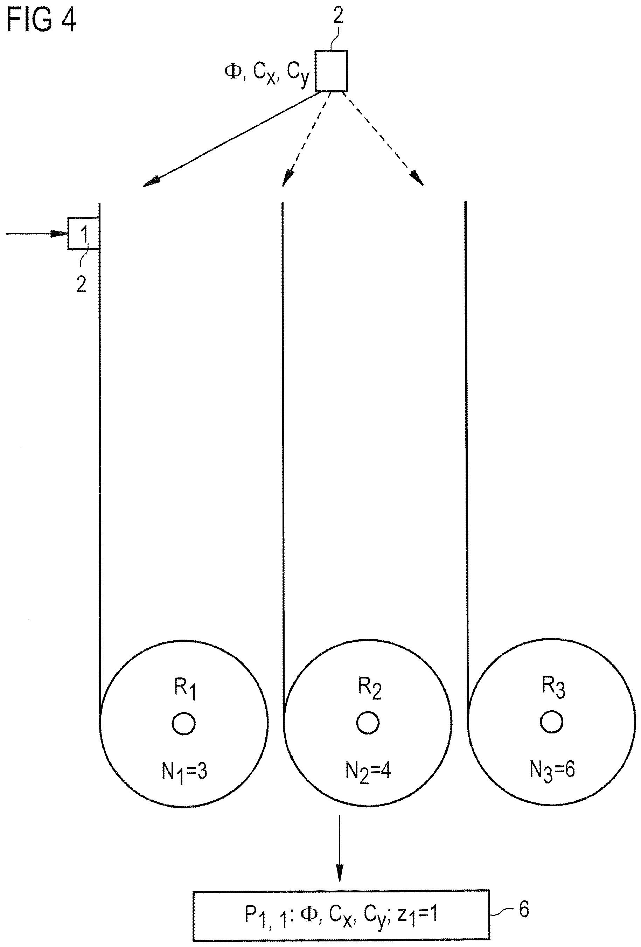

In einem weiteren Verfahrensschritt, der schematisch in Figur 4 dargestellt ist, wird die ausgewählte LED 2 einer der Verpackungseinheiten $R_1$, $R_2$, $R_3$ zugeordnet. Zunächst wird jede der Verpackungseinheiten mit LEDs bestückt, bis die Verpackungseinheiten $R_1$, $R_2$, $R_3$ jeweils $N_m$-1 LEDs aufweisen. Das heißt, dass in jeder der Verpackungseinheiten zunächst derart viele LEDs angeordnet werden, dass die Verpackungseinheiten jeweils eine LED weniger aufweisen als die vorher festgelegte Anzahl $N_m$ von aufeinanderfolgenden LEDs, die in der Verpackungseinheit einen Mittelwert der mindestens einen fotometrischen Messgröße aufweisen sollen, der in dem festgelegten Sollwertebereich liegt. Wie in Figur 4 dargestellt, wird die erste ausgewählte LED 2 beispielsweise als erste LED auf der Rolle $R_1$ angeordnet.

Nach der Anordnung der LED 2 an erster Stelle der Rolle $R_1$ werden vorteilhaft die Position der LED 2 und die dazugehörigen fotometrischen Messgrößen $\Phi$, $C_x$, $C_y$ im Datenspeicher 6 gespeichert. Die Position wird beispielsweise als $P_{m,k}$ notiert, wobei m die Nummer der Verpackungseinheit und k die Nummer der LED 2 in der Verpackungseinheit angibt. Die erste LED der ersten Verpackungseinheit hat also die Position $P_{1,1}$. Ferner wird im Datenspeicher 6 gespeichert, dass in der Verpackungseinheit $R_1$ nun eine Anzahl von $z_1$ = 1 LEDs angeordnet ist.

Auf die gleiche Weise werden weitere LEDs 2 nacheinander aus dem Vorratsbehälter entnommen, die fotometrischen Messgrößen gemessen und die LEDs den Verpackungseinheiten $R_1$, $R_2$, $R_3$ zugeordnet. Bis in jeder der Verpackungseinheiten $R_1$, $R_2$, $R_3$ die Anzahl $N_m$-1 erreicht ist, muss die Zuordnung der jeweils ausgewählten LED 2 zu einer der Verpackungseinheiten nicht nach einer festen Regel erfolgen. Es muss nur die Bedingung erfüllt bleiben, dass vorerst keine der Verpackungseinheiten mit mehr als $N_m$-1 LEDs bestückt wird. Somit können die Verpackungseinheiten $R_1$, $R_2$, $R_3$ bis zu dieser Anzahl von LEDs 2 in den Verpackungseinheiten beispielsweise nacheinander oder nach dem Zufallsprinzip mit LEDs bestückt werden. Es ist allerdings auch möglich, dass anhand der gemessenen fotometrischen Messgrößen bereits eine Auswahl erfolgt, welcher der Verpackungseinheiten $R_1$, $R_2$, $R_3$ die jeweilige ausgewählte LED 2 zugeordnet wird.

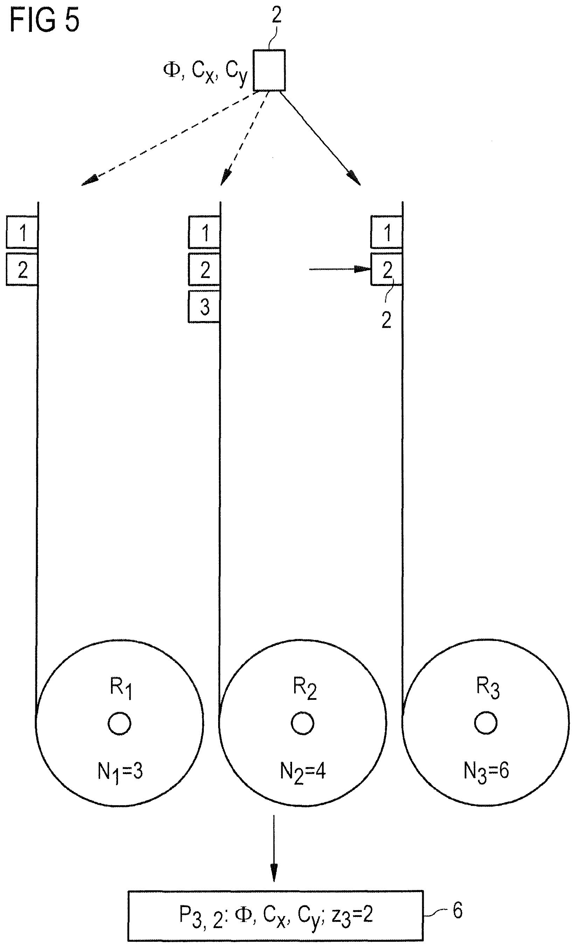

In Figur 5 ist schematisch ein Zwischenschritt des Verfahrens dargestellt, bei dem die erste Verpackungseinheit $R_1$ bereits mit zwei LEDs und die zweite Verpackungseinheit $R_2$ mit drei LEDs bestückt ist. Da für die erste Verpackungseinheit $R_1$ der Wert $N_1$ = 3 festgelegt wurde, ist die erste Verpackungseinheit $R_1$ bereits mit $N_1$-1 = 2 LEDs bestückt. Da für die zweite Verpackungseinheit $R_2$ der Wert $N_2$ = 4 festgelegt wurde, ist auch die zweite Verpackungseinheit $R_2$ bereits mit $N_2$-1 = 3 LEDs bestückt. Folglich wird die ausgewählte LED 2 in der dritten Verpackungseinheit $R_3$ angeordnet, die vor dem Bestücken mit der zusätzlichen LED 2 erst eine LED enthalten hat, sodass die Anzahl der LEDs in der dritten Verpackungseinheit $R_3$ noch weniger als $N_{3-1}$ = 5 beträgt. Nach der Anordnung der ausgewählten LED 2 an der zweiten Stelle der Verpackungseinheit $R_3$ werden der Position $P_{3,2}$ dieser LED 2 die fotometrischen Messwerte $\Phi$, $C_x$, $C_y$ der LED 2 zugeordnet und diese Werte sowie die Anzahl $z_3$ = 2 der LEDs in der dritten Verpackungseinheit $R_3$ in dem Datenspeicher 6 gespeichert.

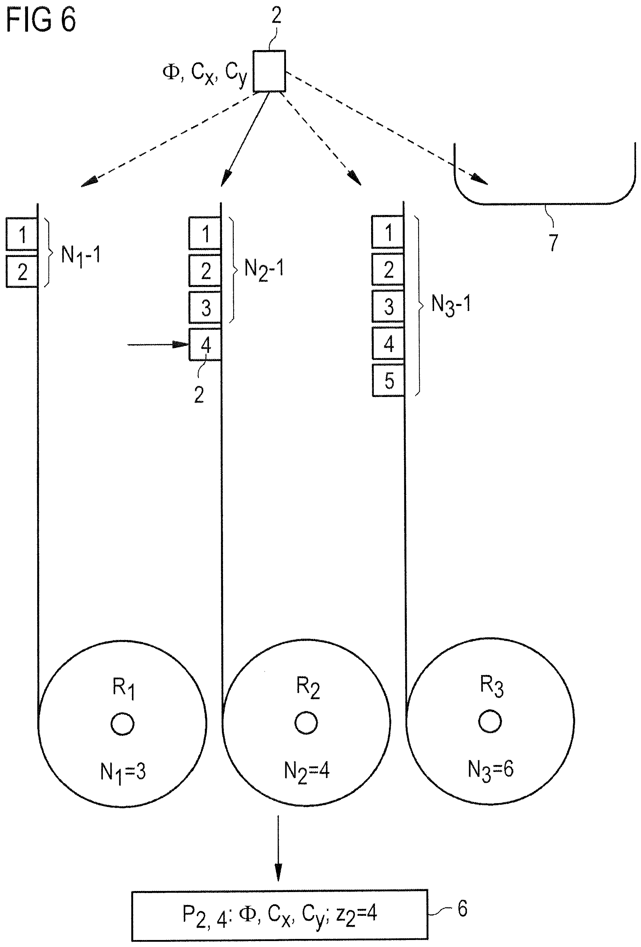

In Figur 6 ist ein Zwischenschritt des Verfahrens dargestellt, bei dem die Verpackungseinheiten $R_1$, $R_2$, $R_3$ schon jeweils mit $N_m$-1 LEDs bestückt sind. Die Zuordnung einer weiteren ausgewählten LED 2, für die die Helligkeit $\Phi$ und die Farbkoordinaten $C_x$, $C_y$ gemessen wurden, zu einer der Verpackungseinheiten $R_1$, $R_2$, $R_3$ erfolgt nun derart, dass zunächst für alle Verpackungseinheiten der Mittelwert der fotometrischen Messgrößen berechnet wird, der sich ergeben würde, wenn man die zusätzliche LED 2 zu den schon vorhandenen $N_m$-1 LEDs hinzufügen würde. Die berechneten Mittelwerte der fotometrischen Messgrößen werden dann mit den für die Verpackungseinheiten zuvor festgelegten Sollwertbereichen verglichen. Es wird also für jede Verpackungseinheit geprüft, ob der Mittelwert

$$\Phi_{avg} = \frac{1}{N_m} \sum_{k=z_m-N_m+1}^{k=z_m+1} \Phi_k$$ in dem für die Verpackungseinheit festgelegten Sollwertbereich $[\Phi_{min}, \Phi_{max}]_m$ liegt. In gleicher Weise wird geprüft, ob die Mittelwerte

$$C_{x,avg} = \frac{1}{N_m} \sum_{k=z_m-N_m+1}^{k=z_m+1} C_{x,k}$$ und

$$C_{y,avg} = \frac{1}{N_m} \sum_{k=z_m-N_m+1}^{k=z_m+1} C_{y,k}$$ in den zuvor festgelegten Sollwertbereichen $[C_{x,min}, C_{x,max}]_m$ und $[C_{y,min}, C_{y,max}]_m$ liegen.

Wenn die berechneten Mittelwerte für eine der m = 1 bis M Verpackungseinheiten in den zuvor festgelegten Sollwertbereichen liegen, wird die ausgewählte LED 2 als nächste LED in dieser Verpackungseinheit angeordnet. Bei dem Beispiel der Figur 6 ist dies beispielsweise für die zweite Verpackungseinheit $R_2$ der Fall, sodass die ausgewählte LED 2 als vierte LED in der zweiten Verpackungseinheit $R_2$ angeordnet wird. Die nun in der zweiten Verpackungseinheit $R_2$ angeordneten ersten vier LEDs erfüllen also die Bedingung, dass die Mittelwerte der fotometrischen Messgrößen $\Phi_{avg}$, $C_{x,avg}$ und $C_{y,avg}$ in den für diese Verpackungseinheit festgelegten Sollwertbereichen liegen. Nach dem Anordnen der LED 2 als vierte LED in der zweiten Verpackungseinheit $R_2$ wird die Position $P_{2,4}$ mit den dazugehörigen fotometrischen Messgrößen $\Phi$, $C_x$, $C_y$ und die aktualisierte Anzahl $z_2 = 4$ LEDs in der zweiten Verpackungseinheit $R_2$ in dem Datenspeicher 6 gespeichert.

Falls für die ausgewählte LED 2 die berechneten Mittelwerte der fotometrischen Messgrößen für keine der Verpackungseinheiten $R_1$, $R_2$, $R_3$ in den zuvor festgelegten Sollwertbereichen liegen, kann die ausgewählte LED 2 beispielsweise in eine Zwischenablage 7 abgelegt werden, sodass sie eventuell zu einem späteren Zeitpunkt einer der Verpackungseinheiten $R_1$, $R_2$, $R_3$ zugeordnet werden kann. Es kann weiterhin auch der Fall eintreten, dass die berechneten Mittelwerte der fotometrischen Messgrößen für mehrere Verpackungseinheiten in den festgelegten Sollwertbereichen liegen. In diesem Fall wäre es also möglich, die ausgewählte LED 2 mehreren Verpackungseinheiten zuzuordnen. In diesem Fall kann die Zuordnung der ausgewählten LED 2 zu einer der geeigneten Verpackungseinheiten nach dem Zufallsprinzip oder nach einer zuvor festgelegten Priorität erfolgen. Beispielsweise kann zuvor festgelegt werden, dass die ausgewählte LED 2 in diesem Fall derjenigen Verpackungseinheit zugeordnet wird, die noch die geringste Anzahl von LEDs aufweist.

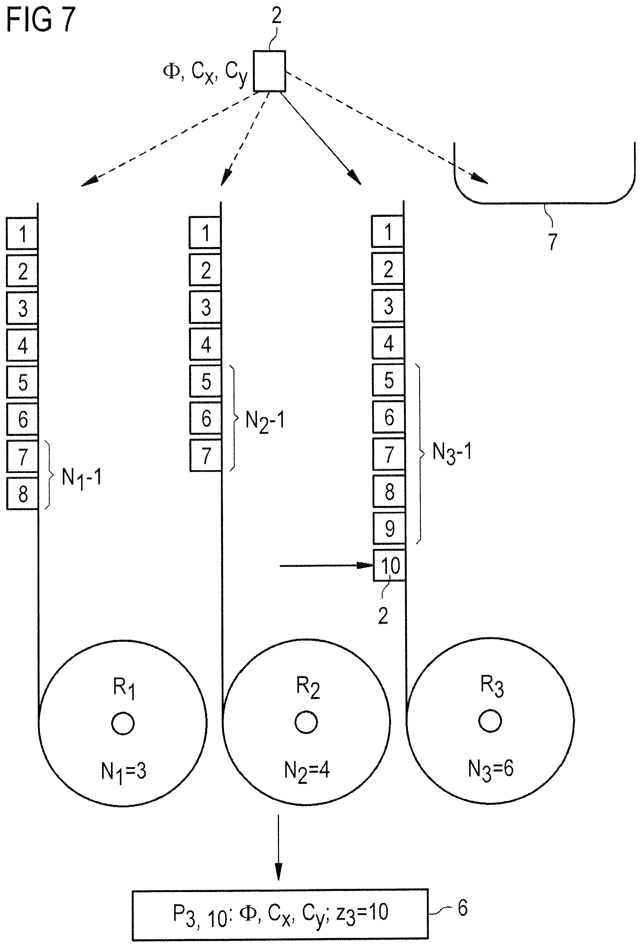

Die nachfolgend aus dem Vorratsbehälter ausgewählten LEDs 2 werden in der gleichen Weise den Verpackungseinheiten $R_1$, $R_2$, $R_3$ zugeordnet, wobei für die Berechnung der Mittelwerte der fotometrischen Messgrößen jeweils die $N_m$-1 zuletzt in der jeweiligen Verpackungseinheit angeordneten LEDs und die jeweils ausgewählte LED 2 herangezogen werden. In Figur 7 ist z. B. ein Zwischenschritt dargestellt, bei dem vor dem Hinzufügen der ausgewählten LED 2 die erste Verpackungseinheit $R_1$ mit acht LEDs, die zweite Verpackungseinheit $R_2$ mit sieben LEDs und die dritte Verpackungseinheit $R_3$ mit neun LEDs bestückt ist. Für die Berechnung des Mittelwerts der fotometrischen Messgrößen werden bei der ersten Verpackungseinheit nun die beiden zuletzt hinzugefügten $N_1$-1 = 2 LEDs, also die siebte und achte LED, sowie die ausgewählte LED 2 herangezogen. Bei der zweiten Verpackungseinheit werden für die Berechnung die zuletzt in dieser Verpackungseinheit angeordneten $N_2$-1 = 3 LEDs, also die fünfte, sechste und siebte LED, und die ausgewählte LED 2 herangezogen. Bei der dritten Verpackungseinheit werden die zuletzt in dieser Verpackungseinheit angeordneten $N_3$-1 = 5 LEDs, also die fünfte, sechste, siebte, achte und neunte LED sowie die ausgewählte LED 2, herangezogen. Bei der Berechnung ergibt sich beispielsweise, dass die ausgewählte LED 2 in Kombination mit den zuletzt in der dritten Verpackungseinheit $R_3$ angeordneten fünf LEDs Mittelwerte der fotometrischen Messgrößen aufweist, die in den zuvor festgelegten Sollwertebereichen liegen. In diesem Fall wird die ausgewählte LED 2 also an der zehnten Stelle in der dritten Verpackungseinheit $R_3$ angeordnet. Folglich werden die Position $P_{3,10}$, die dazugehörigen fotometrischen Messgrößen $\Phi$, $C_x$, $C_y$ und die aktualisierte Anzahl von $z_3 = 10$ LEDs in der dritten Verpackungseinheit $R_3$ in dem Datenspeicher 6 gespeichert.

Durch diese Art der Zuordnung der jeweils ausgewählten LED 2 zu einer der Verpackungseinheiten $R_1$, $R_2$, $R_3$ wird sichergestellt, dass die Mittelwerte der fotometrischen Messgrößen für die zuvor festgelegte Anzahl $N_m$ von aufeinanderfolgenden LEDs mit Sicherheit in den Sollwertebereichen liegen, und zwar unabhängig davon, von welcher Stelle der Verpackungseinheiten $R_1$, $R_2$, $R_3$ die $N_m$ aufeinanderfolgenden LEDs entnommen werden. Es ist dabei auch unerheblich, ob die $N_m$ aufeinanderfolgenden LEDs in der Reihenfolge, in der sie in der Verpackungseinheit angeordnet wurden, oder in umgekehrter Reihenfolge entnommen werden.

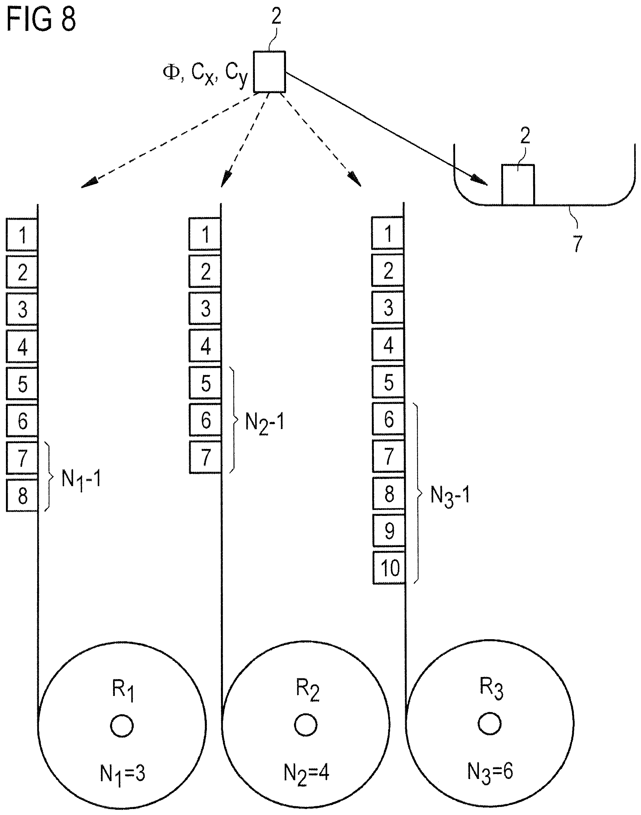

In Figur 8 ist ein Zwischenschritt dargestellt, bei dem nach dem in Figur 7 durchgeführten Zwischenschritt eine weitere ausgewählte LED 2 einer der Verpackungseinheiten $R_1$, $R_2$, $R_3$ zugeordnet werden soll. In diesem Fall stellt sich beispielsweise heraus, dass für keine der Verpackungseinheiten $R_1$, $R_2$, $R_3$ die Bedingung erfüllt ist, dass die zuletzt in der jeweiligen Verpackungseinheit angeordneten $N_m$-1 LEDs in Kombination mit der zusätzlichen ausgewählten LED 2 Mittelwerte der fotometrischen Messgrößen ergeben, die in den zuvor festgelegten Sollwertbereichen liegen. In diesem Fall wird die ausgewählte LED 2 daher keiner der Verpackungseinheiten zugeordnet, sondern in der Zwischenablage 7 abgelegt. Alternativ wäre es auch möglich, die LED 2 wieder in den Vorratsbehälter zu legen, aus dem sie entnommen wurde. Die in der Zwischenablage 7 oder dem Vorratsbehälter abgelegte LED 2 kann zu einem späteren Zeitpunkt einer der Verpackungseinheiten zugeordnet werden.

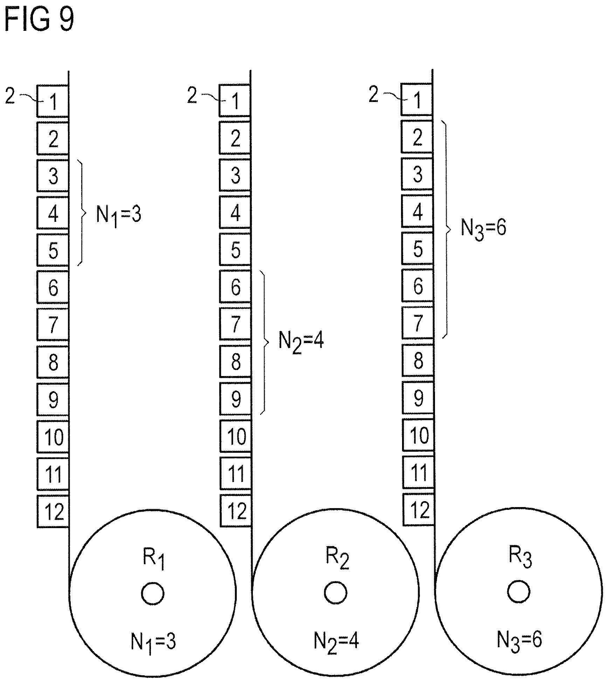

Das zuvor beschriebene Verfahren wird fortgesetzt, bis alle Verpackungseinheiten $R_1$, $R_2$, $R_3$ mit der gewünschten Anzahl von LEDs bestückt sind. In Figur 9 sind beispielsweise die drei Verpackungseinheiten $R_1$, $R_2$, $R_3$ dargestellt, nachdem sie jeweils mit einer Vielzahl von LEDs 2 bestückt wurden. Zur Vereinfachung der Darstellung sind für jede Verpackungseinheit nur jeweils zwölf LEDs 2 dargestellt. Tatsächlich beträgt die bevorzugte Anzahl von LEDs 2, die in den Verpackungseinheiten $R_1$, $R_2$, $R_3$ angeordnet werden, jeweils mindestens 500, mindestens 1000 oder sogar mindestens 5000 LEDs. Typischerweise werden beispielsweise etwa 500 bis 20000 LEDs 2 auf einer als Verpackungseinheit $R_1$, $R_2$, $R_3$ fungierenden Rolle angeordnet.

Bei einer Ausgestaltung der Verpackungseinheiten R$_1$, R$_2$, R$_3$ ist die Gesamtzahl der in den Verpackungseinheiten angeordneten LEDs 2 mindestens um einen Faktor 20 größer als die Anzahl N$_m$ von aufeinanderfolgenden LEDs, für die der Mittelwert der fotometrischen Messgrößen in dem Sollwertebereich liegt. Besonders bevorzugt ist die Gesamtzahl der in den Verpackungseinheiten R$_1$, R$_2$, R$_3$ angeordneten LEDs 2 um mindestens einen Faktor 100 oder sogar um mindestens einen Faktor 500 größer als die Anzahl N$_m$. Die Anzahl N$_m$ von aufeinanderfolgenden LEDs 2, welche die zuvor genannten Bedingungen für den Mittelwert der mindestens einen fotometrischen Messgröße erfüllen, beträgt vorzugsweise zwischen einschließlich 3 und einschließlich 25. Die Verpackungseinheiten R$_1$, R$_2$, R$_3$ sind vorzugsweise jeweils mit der Anzahl N$_m$ gekennzeichnet. Besonders bevorzugt sind die Verpackungseinheiten R$_1$, R$_2$, R$_3$ auch mit der mindestens einen fotometrischen Messgröße, beispielsweise der Helligkeit Φ und dem Farbort C$_x$, C$_y$ sowie den dazugehörigen Sollwertebereichen gekennzeichnet.

Den fertig bestückten Verpackungseinheiten R$_1$, R$_2$, R$_3$ können von einer beliebigen Stelle N$_m$ LEDs entnommen werden, wobei die Mittelwerte der Helligkeit Φ und der Farborte C$_x$, C$_y$ für diese Anzahl von LEDs mit Sicherheit in den Sollwerterbereichen liegen. Beispielsweise könnte man, wie in Figur 8 angedeutet, der ersten Verpackungseinheit R$_1$ die dritte bis fünfte LED, der zweiten Verpackungseinheit R$_2$ die sechste bis neunte oder der dritten Verpackungseinheit die zweite bis sechste LED entnehmen.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

**Patentansprüche**

1. Verfahren zur Anordnung einer Vielzahl von LEDs (2) in Verpackungseinheiten (R$_1$, R$_2$, R$_3$), mit den Schritten:

   a) Festlegung eines Sollwertebereichs für mindestens eine photometrische Messgröße (Φ, C$_x$, C$_y$) für jede der Verpackungseinheiten (R$_1$, R$_2$, R$_3$) wobei der Mittelwert der photometrischen Messgröße (Φ, C$_x$, C$_y$) für eine feste Anzahl von N ≥ 3 aufeinanderfolgenden LEDs (2) in den Verpackungseinheiten (R$_1$, R$_2$, R$_3$) in dem Sollwertebereich liegen soll,
   b) Bereitstellen der Vielzahl von LEDs (2) und der Verpackungseinheiten (R$_1$, R$_2$, R$_3$),
   c) Auswahl einer LED (2) aus der Vielzahl von LEDs (2), die noch nicht in einer der Verpackungseinheiten (R$_1$, R$_2$, R$_3$) angeordnet ist,
   d) Messen der mindestens einen photometrischen Messgröße (Φ, C$_x$, C$_y$) für die ausgewählte LED (2),
   e) Bestücken einer der Verpackungseinheiten (R$_1$, R$_2$, R$_3$), die weniger als N-1 LEDs (2) enthält, mit der ausgewählten LED (2), wobei die LEDs in der Verpackungseinheit (R$_1$, R$_2$, R$_3$) in der Reihenfolge der Bestückung aneinandergereiht werden,
   f) Speichern des Messwerts der mindestens einen photometrischen Messgröße (Φ, C$_x$, C$_y$) und der Position der ausgewählten LED (2) in der Verpackungseinheit (R$_1$, R$_2$, R$_3$) in einem Datenspeicher (6),
   g) Wiederholung der Schritte c) bis f), bis alle Verpackungseinheiten (R$_1$, R$_2$, R$_3$) mit N-1 LEDs bestückt sind,
   h) Wiederholung der Schritte c) und d) und Berechnung des Mittelwerts der mindestens einen photometrischen Messgröße (Φ, C$_x$, C$_y$), der sich jeweils für die zuletzt in der Verpackungseinheit (R$_1$, R$_2$, R$_3$) angeordneten N-1 LEDs und die ausgewählte LED (2) ergibt, wobei diese Berechnung für alle Verpackungseinheiten (R$_1$, R$_2$, R$_3$) durchgeführt wird,
   i) Bestückung einer Verpackungseinheit (R$_1$, R$_2$, R$_3$), für die der berechnete Mittelwert der mindestens einen photometrischen Messgröße (Φ, C$_x$, C$_y$) in dem festgelegten Sollwertebereich liegt, mit der ausgewählten LED (2), wobei die ausgewählte LED (2) in der Verpackungseinheit (R$_1$, R$_2$, R$_3$) derart angeordnet wird, dass sie unmittelbar auf die zuletzt in der Verpackungseinheit angeordnete LED folgt, oder Aussortieren der ausgewählten LED (2), falls der berechnete Mittelwert der photometrischen Messgröße (Φ, C$_x$, C$_y$) für keine der Verpackungseinheiten (R$_1$, R$_2$, R$_3$) in dem festgelegten Sollwertebereich liegt,
   j) Speichern des Messwerts der mindestens einen photometrischen Messgröße (Φ, C$_x$, C$_y$) und der Position der ausgewählten LED (2) in der Verpackungseinheit (R$_1$, R$_2$, R$_3$) in dem Datenspeicher (6), und
   k) Wiederholung der Schritte h) bis j), bis die Verpackungseinheiten (R$_1$, R$_2$, R$_3$) mit einer gewünschten Gesamtzahl von LEDs (2) bestückt sind.

2. Verfahren nach Anspruch 1, wobei die mindestens eine photometrische Messgröße die Helligkeit (Φ) und/oder der Farbort (C$_x$, C$_y$) ist.

3. Verfahren nach einem der vorhergehenden Ansprüche,

wobei die Anzahl der Verpackungseinheiten ($R_1$, $R_2$, $R_3$) mindestens 4 beträgt.

4. Verfahren nach einem der vorhergehenden Ansprüche,
wobei die Verpackungseinheiten ($R_1$, $R_2$, $R_3$) Rollen sind.

5. Verfahren nach einem der vorhergehenden Ansprüche,
wobei die Verpackungseinheiten ($R_1$, $R_2$, $R_3$) mit der Anzahl N der aufeinanderfolgenden LEDs, für die Mittelwert der mindestens einen photometrischen Messgröße ($\Phi$, $C_x$, $C_y$) im Sollwertebereich liegt, gekennzeichnet werden.

6. Verfahren nach einem der vorhergehenden Ansprüche,
wobei die Verpackungseinheiten ($R_1$, $R_2$, $R_3$) mit der mindestens einen photometrischen Messgröße ($\Phi$, $C_x$, $C_y$) und dem Sollwertebereich gekennzeichnet werden.

7. Verfahren nach einem der vorhergehenden Ansprüche,
wobei die Anzahl N zwischen einschließlich 3 und einschließlich 25 beträgt.

8. Verfahren nach einem der vorhergehenden Ansprüche,
wobei die Gesamtzahl der in den Verpackungseinheiten ($R_1$, $R_2$, $R_3$) angeordneten LEDs (2) mindestens um einen Faktor 20 größer ist als die Anzahl N.

9. Verfahren nach einem der vorhergehenden Ansprüche,
wobei die Gesamtzahl der in den Verpackungseinheiten ($R_1$, $R_2$, $R_3$) angeordneten LEDs (2) jeweils mindestens 500 beträgt.

**Claims**

1. Method for arranging a multiplicity of LEDs (2) in packaging units ($R_1$, $R_2$, $R_3$),
comprising the following steps:

   a) defining a desired value range for at least one photometric measurement variable ($\Phi$, $C_x$, $C_y$) for each of the packaging units ($R_1$, $R_2$, $R_3$), wherein the average value of the photometric measurement variable ($\Phi$, $C_x$, $C_y$) for a fixed number of $N \geq 3$ successive LEDs (2) in the packaging units ($R_1$, $R_2$, $R_3$) is intended to lie in the desired value range,
   b) providing the multiplicity of LEDs (2) and the packaging units ($R_1$, $R_2$, $R_3$),
   c) selecting an LED (2) from the multiplicity of LEDs (2), which is not yet arranged in one of the packaging units ($R_1$, $R_2$, $R_3$),
   d) measuring the at least one photometric measurement variable ($\Phi$, $C_x$, $C_y$) for the selected LED (2),
   e) equipping one of the packaging units ($R_1$, $R_2$, $R_3$), which contains fewer than N-1 LEDs (2) with the selected LED (2), wherein the LEDs are strung together in the packaging unit ($R_1$, $R_2$, $R_3$) in the equipping order,
   f) storing the measured value of the at least one photometric measurement variable ($\Phi$, $C_x$, $C_y$) and the position of the selected LED (2) in the packaging unit ($R_1$, $R_2$, $R_3$) in a data memory (6),
   g) repeating steps c) to f), until all of the packaging units ($R_1$, $R_2$, $R_3$) are equipped with N-1 LEDs,
   h) repeating steps c) and d) and calculating the average value of the at least one photometric measurement variable ($\Phi$, $C_x$, $C_y$), which respectively results for the N-1 LEDs last arranged in the packaging unit ($R_1$, $R_2$, $R_3$) and the selected LED (2), wherein this calculation is carried out for all of the packaging units ($R_1$, $R_2$, $R_3$),
   i) equipping a packaging unit ($R_1$, $R_2$, $R_3$), for which the calculated average value of the at least one photometric measurement variable ($\Phi$, $C_x$, $C_y$) lies in the defined desired value range with the selected LED (2), wherein the selected LED (2) is arranged in the packaging unit ($R_1$, $R_2$, $R_3$) in such a way that it directly follows the LED last arranged in the packaging unit, or sorting out the selected LED (2), if the calculated average value of the photometric measurement variable ($\Phi$, $C_x$, $C_y$) does not lie in the defined desired value range for any of the packaging units ($R_1$, $R_2$, $R_3$),
   j) storing the measured value of the at least one photometric measurement variable ($\Phi$, $C_x$, $C_y$) and the position of the selected LED (2) in the packaging unit ($R_1$, $R_2$, $R_3$) in the data memory (6), and
   k) repeating steps h) to j), until the packaging units ($R_1$, $R_2$, $R_3$) are equipped with a desired total number of LEDs (2).

2. Method according to Claim 1,
wherein the at least one photometric measurement variable is the brightness ($\Phi$) and/or the colour locus ($C_x$, $C_y$).

3. Method according to either of the preceding claims,
wherein the number of packaging units ($R_1$, $R_2$, $R_3$) is at least 4.

4. Method according to any of the preceding claims,
wherein the packaging units ($R_1$, $R_2$, $R_3$) are rolls.

**5.** Method according to any of the preceding claims, wherein the packaging units ($R_1$, $R_2$, $R_3$) are identified with the number N of successive LEDs for which the average value of the at least one photometric measurement variable ($\Phi$, $C_x$, $C_y$) lies in the desired value range.

**6.** Method according to any of the preceding claims, wherein the packaging units ($R_1$, $R_2$, $R_3$) are identified with the at least one photometric measurement variable ($\Phi$, $C_x$, $C_y$) and the desired value range.

**7.** Method according to any of the preceding claims, wherein the number N is between 3 and 25 inclusive.

**8.** Method according to any of the preceding claims, wherein the total number of the LEDs (2) arranged in the packaging units ($R_1$, $R_2$, $R_3$) is greater than the number N at least by a factor of 20.

**9.** Method according to any of the preceding claims, wherein the total number of the LEDs (2) arranged in the packaging units ($R_1$, $R_2$, $R_3$) is in each case at least 500.

**Revendications**

**1.** Procédé pour placer une pluralité de DEL (2) dans des unités d'emballage ($R_1$, $R_2$, $R_3$), avec les étapes suivantes :

  a) la détermination d'une plage de valeurs de consigne pour au moins une grandeur de mesure photométrique ($\Phi$, $C_x$, $C_y$) pour chacune des unités d'emballage ($R_1$, $R_2$, $R_3$), dans lequel la valeur moyenne de la grandeur de mesure photométrique ($\Phi$, $C_x$, $C_y$) pour un nombre fixe de $N \geq 3$ DEL (2) successives dans les unités d'emballage ($R_1$, $R_2$, $R_3$) doit se situer dans la plage de valeurs de consigne,
  b) la mise à disposition de la pluralité de DEL (2) et des unités d'emballage ($R_1$, $R_2$, $R_3$),
  c) la sélection d'une DEL (2) parmi la pluralité de DEL (2), laquelle n'est pas encore disposée dans l'une des unités d'emballage ($R_1$, $R_2$, $R_3$),
  d) la mesure de l'au moins une grandeur de mesure photométrique ($\Phi$, $C_x$, $C_y$) pour la DEL (2) sélectionnée,
  e) l'équipement d'une des unités d'emballage ($R_1$, $R_2$, $R_3$), contenant moins de N-1 DEL (2), avec la DEL (2) sélectionnée, dans lequel les DEL dans l'unité d'emballage ($R_1$, $R_2$, $R_3$) sont juxtaposées dans l'ordre d'équipement,
  f) l'enregistrement de la valeur de mesure de l'au moins une grandeur de mesure photométrique ($\Phi$, $C_x$, $C_y$) et de la position de la DEL (2) sélectionnée dans l'unité d'emballage ($R_1$, $R_2$,

$R_3$) dans une mémoire de données (6),
  g) la répétition des étapes c) à f) jusqu'à ce que toutes les unités d'emballage ($R_1$, $R_2$, $R_3$) soient équipées de N-1 DEL,
  h) la répétition des étapes c) et d) et le calcul de la valeur moyenne de l'au moins une grandeur de mesure photométrique ($\Phi$, $C_x$, $C_y$), laquelle résulte respectivement pour les N-1 DEL disposées en dernier dans l'unité d'emballage ($R_1$, $R_2$, $R_3$) et la DEL (2) sélectionnée, dans lequel ce calcul est réalisé pour toutes les unités d'emballage ($R_1$, $R_2$, $R_3$),
  i) l'équipement d'une unité d'emballage ($R_1$, $R_2$, $R_3$), pour laquelle la valeur moyenne calculée de l'au moins une grandeur de mesure photométrique ($\Phi$, $C_x$, $C_y$) se situe dans la plage de valeurs de consigne déterminée, avec la DEL (2) sélectionnée, dans lequel la DEL (2) sélectionnée est disposée dans l'unité d'emballage ($R_1$, $R_2$, $R_3$) de manière à directement suivre la DEL disposée en dernier dans l'unité d'emballage,
  ou le tri de la DEL (2) sélectionnée si la valeur moyenne calculée de la grandeur de mesure photométrique ($\Phi$, $C_x$, $C_y$) ne se situe dans la plage de valeurs de consignes déterminée pour aucune des unités d'emballage ($R_1$, $R_2$, $R_3$),
  j) l'enregistrement de la valeur de mesure de l'au moins une grandeur de mesure photométrique ($\Phi$, $C_x$, $C_y$) et de la position de la DEL (2) sélectionnée dans l'unité d'emballage ($R_1$, $R_2$, $R_3$) dans la mémoire de données (6), et
  k) la répétition des étapes h) à j) jusqu'à ce que les unités d'emballage ($R_1$, $R_2$, $R_3$) soient équipées d'un nombre total souhaité de DEL (2).

**2.** Procédé selon la revendication 1, dans lequel l'au moins une grandeur de mesure photométrique est la luminosité ($\Phi$) et/ou la localisation chromatique ($C_x$, $C_y$).

**3.** Procédé selon l'une des revendications précédentes, dans lequel le nombre d'unités d'emballage ($R_1$, $R_2$, $R_3$) est au moins de 4.

**4.** Procédé selon l'une des revendications précédentes, dans lequel les unités d'emballage (tri, $R_2$, $R_3$) sont des rouleaux.

**5.** Procédé selon l'une des revendications précédentes, dans lequel les unités d'emballage ($R_1$, $R_2$, $R_3$) sont **caractérisées par** le nombre N des DEL successives pour lesquelles la valeur moyenne de l'au moins une grandeur de mesure photométrique ($\Phi$, $C_x$, $C_y$) se situe dans la plage de valeurs de consigne.

**6.** Procédé selon l'une des revendications précédentes, dans lequel les unités d'emballage ($R_1$, $R_2$, $R_3$)

sont **caractérisées par** l'au moins une grandeur de mesure photométrique ($\Phi$, $C_x$, $C_y$) et la plage de valeurs de consigne.

7. Procédé selon l'une des revendications précédentes, dans lequel le nombre N est compris entre 3 inclusivement et 25 inclusivement.

8. Procédé selon l'une des revendications précédentes, dans lequel le nombre total de DEL (2) disposées dans les unités d'emballage ($R_1$, $R_2$, $R_3$) est supérieur au moins d'un facteur de 20 au nombre N.

9. Procédé selon l'une des revendications précédentes, dans lequel le nombre total de DEL (2) disposées dans les unités d'emballage ($R_1$, $R_2$, $R_3$) est respectivement au moins de 500.

## FIG 1

FIG 2

FIG 3

$\Phi, C_x, C_y$

## FIG 4

$\Phi$, $C_x$, $C_y$ $\boxed{\phantom{xx}}$ 2

$\boxed{1}$
2

$R_1$
○
$N_1 = 3$

$R_2$
○
$N_2 = 4$

$R_3$
○
$N_3 = 6$

$$P_{1,\,1}: \Phi,\ C_x,\ C_y;\ z_1 = 1 \qquad 6$$

# FIG 5

$\Phi, C_x, C_y$

2

1
2

1
2
3

1
2
2

$R_1$

○

$N_1=3$

$R_2$

○

$N_2=4$

$R_3$

○

$N_3=6$

$P_{3,2}: \Phi, C_x, C_y; z_3=2$

6

# FIG 6

$\Phi, C_x, C_y$ □ 2

□ 1
□ 2 } $N_1\text{-}1$

□ 1
□ 2
□ 3 } $N_2\text{-}1$
→ □ 4
2

□ 1
□ 2
□ 3 } $N_3\text{-}1$
□ 4
□ 5

7

$R_1$
○
$N_1=3$

$R_2$
○
$N_2=4$

$R_3$
○
$N_3=6$

$P_{2,4}: \Phi, C_x, C_y; z_2=4$  —6

# FIG 7

$\Phi, C_x, C_y$ $\boxed{\phantom{2}}$ 2

$\boxed{1}$     $\boxed{1}$     $\boxed{1}$      7

$\boxed{2}$     $\boxed{2}$     $\boxed{2}$

$\boxed{3}$     $\boxed{3}$     $\boxed{3}$

$\boxed{4}$     $\boxed{4}$     $\boxed{4}$

$\boxed{5}$     $\boxed{5}$     $\boxed{5}$

$\boxed{6}$     $\boxed{6}$ $\}$ $N_2-1$     $\boxed{6}$

$\boxed{7}$ $\}$     $\boxed{7}$     $\boxed{7}$ $\}$ $N_3-1$

$\boxed{8}$ $\}$ $N_1-1$       $\boxed{8}$

                          $\boxed{9}$

$\longrightarrow$ $\boxed{10}$

                          2

$R_1$       $R_2$       $R_3$

$\bigcirc$       $\bigcirc$       $\bigcirc$

$N_1=3$     $N_2=4$     $N_3=6$

$$\boxed{P_{3,\,10}: \Phi, C_x, C_y;\ z_3=10}$$ 6

# FIG 8

$\Phi, C_x, C_y$

2

2

7

| 1 | 1 | 1 |
| 2 | 2 | 2 |
| 3 | 3 | 3 |
| 4 | 4 | 4 |
| 5 | 5 | 5 |
| 6 | 6 | 6 |
| 7 | 7 | 7 |
| 8 |   | 8 |
|   |   | 9 |
|   |   | 10 |

$N_1-1$

$N_2-1$

$N_3-1$

$R_1$

$R_2$

$R_3$

$N_1=3$

$N_2=4$

$N_3=6$

FIG 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011103752
- JP 2008147563 A